# EUROPÄISCHE PATENTSCHRIFT

(11) **EP 0 347 579 B1**
(45) Veröffentlichungstag und Bekanntmachung des Hinweises auf die Patenterteilung: **30.03.1994**
(21) Anmeldenummer: 89108748.8
(22) Anmeldetag: 16.05.1989
(51) Int. Cl.: B01L 3/00, G01N 21/03, G01N 27/30

(54) **Vorrichtung mit Träger besonderer Struktur zur Aufnahme, Untersuchung und Behandlung von Proben**
Device having a specific support structure for receiving, analysing and treating samples
Dispositif comportant un support de structure particulière pour la réception, l'analyse et le traitement d'échantillons

(30) Priorität: 01.06.1988 DE 3818614; 29.07.1988 DE 3825907
(43) Veröffentlichungstag der Anmeldung: 27.12.1989
(73) Patentinhaber: Daimler-Benz Aerospace Aktiengesellschaft, 81663 München (DE)
(72) Erfinder: Kroy, Walter, Dr., D-8012 Ottobrunn (DE); Seidel, Helmut, Dr., D-8130 Starnberg (DE); Dette, Eduard, D-8152 Vagen (DE); Königer,Max,Dr., D-8000 München 71 (DE); Deimel,Peter,Dr., D-8059 Langenpreising (DE); Binder,Florian,Dr., D-8220 Traunstein (DE); Hilpert,Reinhold,Dr., D-8000 München 70 (DE)

(56) Entgegenhaltungen:
- EP-A- 0 012 035
- EP-A- 0 215 546
- GB-A- 2 218 511
- US-A- 4 240 751
- PROCEEDINGS OF THE IEEE, Band 70, Nr. 5, Mai 1982, Seiten 420-457, New York,US; K.E. PETERSEN: "Silicon as a mechanical material"
- STUDIES IN ELECTRICAL & ELECTRONIC ENGINEERING,Band 20, 1985, MICROMACHINING & MICROPACKAGING OF TRANSDUCERS, Seiten 107-124, Elsevier, NL; D.L. KENDALL etal.: "Orientations of the third kind: The coming of age (110) silicon"

## Beschreibung

Die Erfindung betrifft eine mikromechanische Struktur für Zwecke der Biotechnologie, also insbesondere gegen Krankheit und Hunger, für Zwecke der Biotechnik, der Gentechnik, der Zellforschung, für die Pharmazie, zur Heilung und Erforschung insbesondere bisher unheilbarer Krankheiten, auch für die Agrarforschung, um neue Nahrungsquellen und Energiequellen zu erschließen und die Umwelt wiederherzustellen. Für Zwecke der Medizin, z.B. Blutuntersuchungen aber auch von Gewebe oder von Zellen, z.B. Antikörper-, Antigenimmobilisierung zur Herstellung von monoklonalen Antikörpern, zur Herstellung von Antibiotika, Insulin, aber auch für Heilmittel, Seren, Bakterien und anderen Substanzuntersuchungen und Vergleichsversuche. Immer besteht die Aufgabe eines sicheren kontollierten Umgangs mit der jeweiligen Substanz vor, während und nach einer Untersuchung, Reaktion oder dergleichen, insbesondere wenn die Substanzen eine Gefahr für die Umwelt bilden können.

Um die eingangs genannten Zwecke erfüllen zu können, insbesondere zur Bekämpfung von Krankheit und Hunger in der Welt, ist es nötig, bei Untersuchungen, Reaktionen, Tests, Vergleichsuntersuchungen bzw. Untersuchungsreihen mit insbesondere gefährlichen Substanzen auch dann sicher hantieren zu können, wenn die Substanzmengen noch so gering sind.

Aufgabe der Erfindung ist es, eine reine, sichere Aufbewahrung und Handhabung von Substanzen, die gefährlich sind oder werden können - sei es vor, während oder nach einer Untersuchung, Reaktion, Test oder ähnlichem - zu erleichtern bzw. zu gewährleisten.

Gelöst wird diese Aufgabe durch eine Mikrostruktur gemäß Patentanspruch 1. Diese Mikrostruktur weist viele Vorteile auf. Sie kann in großen Stückzahlen kostengünstig hergestellt werden. Sie ist für eine sichere Aufbewahrung einer Vielzahl von Substanzen als Proben für Tests, für Behandlungen, für Untersuchungen, für Vergleiche, für Reaktionen etc. geeignet. Die Anordnung von geeigneten Kavitäten zueinander in der Struktur nach Art einer Matrix bzw. eines Arrays gestattet einfache Prozeßsteuerung, einfache Untersuchung und Durchführung von gewünschten Reaktionen, von gewünschten kleinen Substanzmengen sowie deren gezielte Behandlung und Untersuchung. Die Struktur mit den Kavitäten besteht aus inertem Material, d.h. sie ändert sich bei den Untersuchungen, Behandlungen nicht, die Kavitäten sind zuverlässig verschließbar und werden von den meisten Schadstoffen nicht angegriffen.

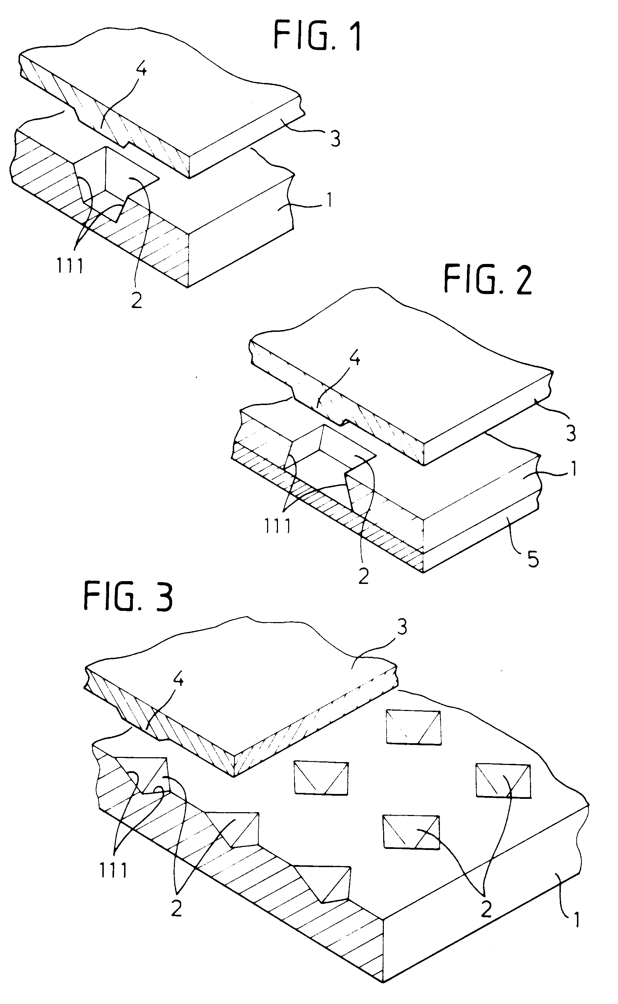

Aus- und Weiterbildungen der Erfindung sind weiteren Ansprüchen sowie der Beschreibung und Zeichnung eines Ausführungsbeispiels zu entnehmen. Auch Kombinationen dieser Merkmale gehören zur Erfindung. In der Zeichnung zeigen:
- Fig. 1: eine Struktur mit einer einzelnen Kavität und einer bestimmten Oberflächenorientierung des kristallinen Materials;
- Fig. 2: eine Abwandlung von Figur 1;
- Fig. 3: eine Struktur aus kristallinem Material;
- Fig. 4: eine Struktur in Abwandlung zu Figur 3;
- Fig. 5: eine Struktur in konstruktiver Abwandlung zu Figur 1;
- Fig. 6: eine Abwandlung zu Fig. 2 oder 4, wobei ein strukturiertes Teil in der Mitte zwischen zwei hiervon verschiedenen Teilen angeordnet ist (Sandwich-Aufbau);
- Fig. 7: eine Abwandlung zu Fig. 6 mit in Bodenplatte und Deckplatte zusätzlich angeordneten Einrichtungen;
- Fig. 8: eine weitere Abwandlung zu Fig. 6 oder 7 mit zusätzlichen Schichten oder Platten;
- Fig. 9: eine Ausführung mit Meß- oder Erfassungseinrichtung;
- Fig. 10: eine Struktur mit Meß- und Erfassungseinrichtung sowie gegebenenfalls Speicher;
- Fig. 11: eine Einrichtung mit einem Biosensor insbesondere Feldeffekttransistor;
- Fig. 12: eine Abwandlung der Ausführungsform nach Fig. 11;
- Fig. 13: eine Einrichtung zum Feststellen bestimmter Stoffe in Fluiden;
- Fig. 14: eine Einrichtung zur automatischen Untersuchung mit Dokumentation der Untersuchungsergebnisse;
Wie Fig. 1 zeigt, besteht eine Struktur 1 aus Wandungen mit einer, bevorzugt mehreren Kavitäten darin, zur Aufnahme kleiner Substanzmengen, und der Block ist abgeschlossen von einem Deckel 3. Block 1 und Deckel 3 sind aus kristallinem Material, wie Halbleitermaterial. Ebenso wird zum erfindungsgemäßen Verschluß des Behälters mit einer zweiten Maske ein Gegenstück erzeugt = Deckel 3, der zu den Vertiefungen 2 korrespondierende Erhebungen 4 aufweist, da die Masken geometrisch identisch sind. Die Maskentechnik erlaubt eine hohe Präzision bei der Herstellung; sie ist an sich aus der Halbleitertechnik bekannt.

Bei der genannten Technik ist von Vorteil, ein kristallrichtungsabhängiges anisotropes Ätzverfahren anzuwenden, weil sich dadurch, unter Ausnutzung der selbstbegrenzenden Wirkung von (111) Kristallebenen, Vertiefungen mit hoher geometrischer Präzision und sehr engen Toleranzen realisieren lassen. Der Behälter in Fig. 1 kann auf (100) Silizium hergestellt werden, wobei die seitlich begrenzenden (111) Ebenen einen Winkel von 54,7° zur Scheibenoberfläche aufweisen.

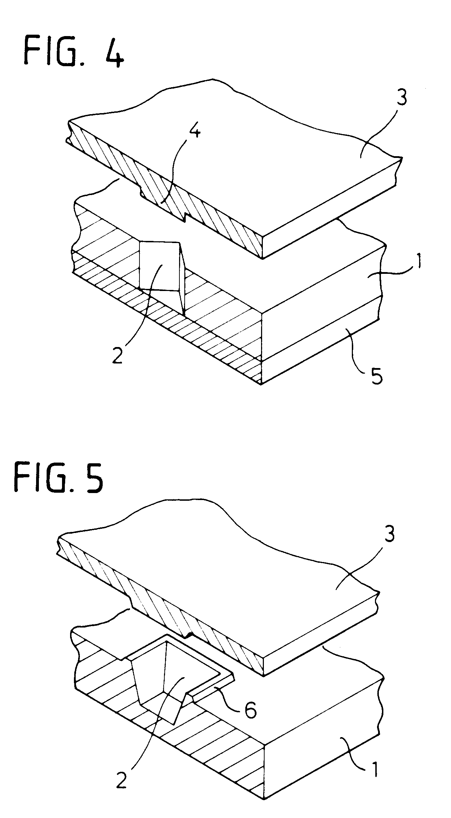

Der Deckel 3 kann mit einer Erhebung 4 versehen werden, die die gleiche 54,7°-Neigung zur Kristalloberfläche aufweist wie der Behälterblock 1 im Bereich 2 und dadurch einwandfrei dicht abschließt. Das gilt auch dann, wenn der Deckel eine Vielzahl von Erhebungen, und der Block 1 eine Vielzahl von Vertiefungen 2 aufweist. Sollte die Passgenauigkeit, der im Ätzverfahren hergestellten Erhebungen und Vertiefungen an Deckel 3 und Block 1 für einzelne Anwendungen von besonders gefährlichen Substanzen nicht ausreichen, kann zusätzlich eine umlaufende Dichtung verwendet werden. Fig. 5 zeigt eine Ausführung, die ihrerseits mit der 54,7°-Schräge der Erhebung 4 des Deckels korrespondiert und mit einer weiteren einen Verschluß bilden. Außerdem können Klebstoffe oder andere Verbindungstechniken zur Erhöhung der Dichtheit angewandt werden. Insbesondere kann auch ein Laserstrahl im Naht-Schweißverfahren am umlaufenden Rand des Deckels angewandt werden. Eine Vielzahl von Kavitäten 2 ist nach Größe, Ausbildung und Verteilung im Block des Behälters nicht beschränkt.

Die Kavitäten 2 (und die Erhebungen 4) können insbesondere quadrat-, rechteck-, kreisförmig, oval oder rautenförmig sein. Sie können sich nach unten hin verjüngen oder erweitern - vergleiche Fig. 1 und Fig. 2 - oder gleichen Querschnitt behalten, wenn sie z.B. mittels Laserstrahl gebohrt sind (Fig. 4). Sie können auch andere Querschnitte oder Formen aufweisen (Öffnungen, Kanäle bilden).

Eine zusätzliche Schicht oder Platte 5 dient als Träger oder Zwischenträger (wieder entfernbar) mit Vorteil aus gleichem Material, z.B. Silizium o.ä., als Boden des Behälters, ebenfalls hermetisch dicht abschließend.

Die aus einem Blockmaterial herausgearbeitete Struktur 1 bildet in vorteilhafter Weise (für Massenherstellung) eine ebene Platte mit durchgehenden Kavitäten 2 wie Öffnungen, Kanälen oder dergleichen gewünschter Form naß chemisch geätzt mit Vorteil aus Silizium während Deckel 3 und Boden 5 aus mit diesem Material der Struktur 1 vorzugsweise gut verbindbaren, insbesondere hermetisch dicht abschließbarem Material bestehen wie Glas, Quarzglas, Glaskeramik oder Siliziumkunststoff oder Siliziummetallverbundmaterial.

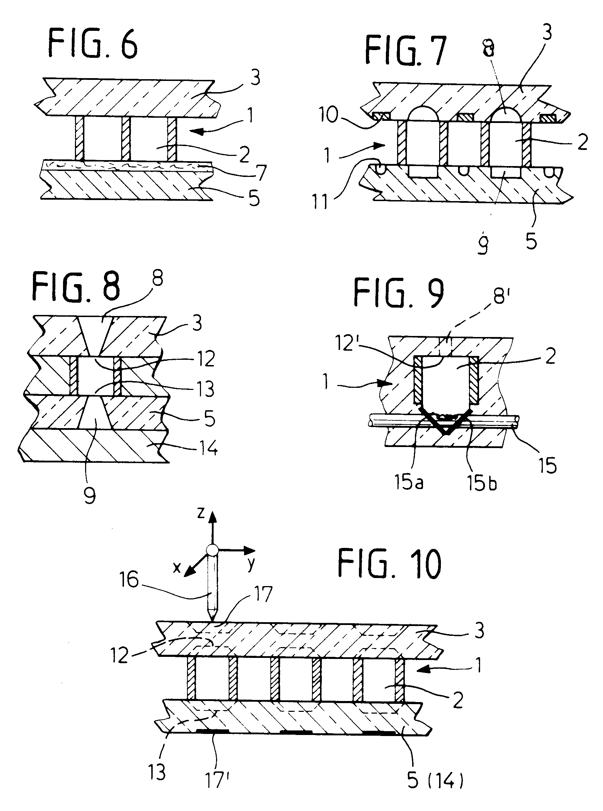

In Fig. 6 ist wie dargestellt, der Boden 5 noch zur Struktur 1 hin mit einer Schicht 7 belegt, die z.B. eine Filterschicht, eine Sedimentationsschicht, eine inerte, oder katalytische oder sonst reagierende Schicht eines Materials oder auch nur aufsaugenden Materials, sein kann. Ein Faservlies oder anderes großporiges oder mit großer offener Fläche versehenes Gewebevlies, Fasergelege, Schaumstoff oder ähnlich durchlässiges Gebilde kann je nach Anwendungszweck (Sammeln, Aufbewahren, Reagieren) verwendet werden. Es kann sich um ein neutrales Trägermaterial oder um ein aktives Trägermaterial handeln, das für die Schicht 7 benutzt wird und unterhalb könnten gegenenfalls Ventile oder weitere Einrichtungen (vgl Fig. 8) angeordnet werden. Der Block 1 mit den Kavitäten 2 enthält diese vorteilhaft nach einem Rastermaß in X-Y über die Oberfläche des bevorzugten Siliziumkristalls verteilt angeordnet als Array bzw. in Matrixform (vgl. Fig. 3), so daß sie z.B. mittels automatischer Einrichtungen mit Substanzen befüllt, begast, beimpft, verdünnt, verarmt, abgesaugt oder dergl., vermischt oder zur Reaktion gebracht werden können. Die Zufuhr- oder Entnahmeorgane werden dann Zeile für Zeile programmgesteuert, bis die gesamte Oberfläche abgerastert ist, wie an sich bei Analyseautomaten oder Handhabungsautomaten oder Robotern für medizinische oder andere Forschungszwecke bekannt.

Das Material des Blocks 1 muß in jedem Fall inert sein gegenüber der Substanz, die untersucht, behandelt, verdünnt, gemischt werden soll oder zu einer Reaktion gebracht werden soll oder auf ihr Ausbleiben getestet wird (Vergleichs- oder Antitests).

Je nach dem Zweck, für den die Erfindung angewandt wird, können die Kavitäten für die Untersuchung oder Aufbewahrung (Lagerbehälter) größer gestaltet werden insbesondere, in dem die Kavitäten 2 in Block 1 nur Teil von Probe- oder Untersuchungs- oder Reaktionskammern sind - siehe Fig. 7. Die Matrix oder Arrayanordnung in X-Y-Richtung wird wie vorbeschrieben beibehalten und auch der im wesentlichen sandwichartige Aufbau nach Fig. 6. Zusatzlich wird in der Deckplatte 3 und in der Bodenplatte 5 jeweils der Kavität eine weitere passende Vertiefung 8 oder 9 zugeordnet, die insgesamt gesehen das Kammervolumen oder Volumen der Kavität 2 erheblich vergrößert. Nunmehr kann die Zu- oder Abfuhr eines Mediums auch in der Zeichenebene erfolgen, wenn z.B. das gleiche Medium allen Kammern zu- oder abgeführt werden soll.

In aller Regel werden für die eingangs genannten Zwecke Stoffe wie Feststoffe in einem Fluid untersucht; es können auch Gase in einer Flüssigkeit oder Gase oder Flüssigkeit in einem Feststoff untersucht werden. Dies gilt insbesondere für Immunreaktionen, für das Untersuchen von Enzymen oder Mikroorganismen. Es können bei Untersuchungen oder Analysen von Substanzen/Gemischen chemische oder physikalische Eigenschaften oder deren Änderung festgestellt werden hinsichtlich einer oder mehrerer Eigenschaften wie Strömung, Dichte, Oberflächen- oder Grenzeffekte, besondere Merkmale von Teilchen, Durchlässigkeit, Reibung, Adhäsion. Es kann im einfachsten Falle ein Aufbewahren unter bestimmten Bedingungen wie Druck oder Vakuum über eine bestimmte Zeit untersucht werden oder unter äußerer Einwirkung kann eine Reaktion hierauf oder das Ausbleiben einer Reaktion untersucht werden. Äußere Einflüsse können sein: Strahlung, Wärmebehandlung, Anwendung von Reagenzien, das Messen der Veränderung von Stoffeigenschaften bei Hitze, Kälte, Dampf, Feuchtigkeit oder zugeführten Stoffen/Partikeln, durch Anwendung elektrischer/elektrochemischer oder magnetischer Mittel, durch Anwendung von Schall, Infraschall, Ultraschall. Ferner können kolorimetrische, spektrophotometrische oder fluororometrische Untersuchungen, z.B. unter Verwendung von Reagenzschichten wie Reagenzpapieren als Schicht 7 durchgeführt werden. Heiz- und/oder Kühlelemente können in Form von jeweils temperierten Medien in Kanälen 10 und 11 z.B. durch die Platten 3 und 5 an die Kammern 2 herangeführt werden oder es können Thermoelemente, insbesondere Peltierelemente wenigstens teilweise im Bereich dieser Kavitäten angeordnet sein. Substanzen können mit fluoreszierenden Markierungen, mit radioaktiven Markierungen oder mit Enzymmarkierungen mit Trägern oder ohne Trägern, gebunden oder trennbar, organisch oder anorganisch, mit Zellen oder Zellfragmenten, Gel oder anderem zum Nachweis von Mikroorgansimen, Bakterien, Viren und anderem verwendet werden, aber auch zum Nachweis von Krebs, zur Bestimmung von einzelnen Stoffen im Blut oder zur Bestimmung vom PH-Wert, von Blutzucker, von Blutcholesterin oder zur Feststellung von Narkotika oder anderem im Blut. Geeignete Untersuchungsmethoden, insbesondere biologische/medizinische, chemikalische/physikalische sind bekannt, besonders bei Blutuntersuchung, zur Untersuchung von Seren etc. Auch Untersuchungsmethoden für andere Körperflüssigkeiten wie Lymphflüssigkeit, Urin etc. sind bekannt, je nachdem, ob kleine Teilchen markiert oder unmarkiert, organisch/anorganisch, mit oder ohne Träger bekannter Art verwendet werden, empfehlen sich Durchleuchtungen mittels Röntgenstrahlen, aber auch Untersuchungen mit Hilfe von Gammastrahlen, mit sichtbarem Infrarotlicht oder ultraviolettem Licht (optische Verfahren). Auswerteverfahren mit Hilfe von Lichtleitern sind beispielsweise in Fig. 9 und 10 dargestellt. Bei Untersuchungen der Fließeigenschaften von Stoffen oder Stoffgemischen ist vorteilhaft, wie Fig. 8 zeigt, den Zufluß, Abfluß oder beide (Durchfluß) mit Hilfe von Mikroventilen 12 und 13 in Deckel oder Boden 5 des Blocks 1 mit den Mikrokavitäten 2 zu steuern. Die Mikroventile selbst sind an sich bekannt (vergl z.B. EP-A-0 250 948). Sie werden bevorzugt in dem gleichen Array bzw. in der gleichen Matrix in X-Y-Richtung angeordnet wie die Kavitäten 2 im Block 1 und ergeben dadurch eine einfache Auswertemöglichkeit für jeweilige Untersuchungen. Im Boden 5 kann eine Schicht 7 wie in Fig. 6 angeordnet sein. Unterhalb des Bodens 5 kann noch eine weitere Träger- oder Abschlußplatte 14 angeordnet sein, die auch eine Erfassungseinrichtung z.B. Photoelemente in gleicher Arrayanordnung zur Auswertung an ein Mikroprozessor (hier nicht dargestellt). weiterleiten kann. Die Leitungen für Zu- und Abfuhr von Substanzen, Reagenzen etc. sind nicht dargestellt, ebensowenig die Strahlenquellen, welche in Fig. 8 vorteilhaft von oben, d.h. oberhalb des Deckels 3, einstrahlen. Die Teile 3 und 5 können auch in Fig. 8 mit Vorteil aus Glas, Quarzglas oder Siliziumkeramik oder einem Silizium-Verbundwerkstoff bestehen und wenigstens teilweise transparent, wenigstens teilweise verspiegelt sein. Deckel oder Boden können unter Umständen auch durch Folienbänder aus lichtundurchlässigem Material wenigstens teilweise ersetzt werden, z.B. kann auch über den Deckel 3, falls dieser die Mikroventile enthält, noch eine Kunststoffolie geklebt werden, die einen hermetisch dichten Verschluß herbeiführt, jedoch von einer Hohlnadel durchstochen werden kann. Folien oder Schichten können optisch durch- oder undurchlässig sein, sie können als Heizschichten 10 oder Wärmesenke 11 ausgeführt sein oder für optische Zwecke spiegelnd/nichtspiegelnd, für bestimmte Wellenlängen durchlässig, filternd, teiltransparent oder ähnlich ausgebildet sein. Auch sind Kohlenstoff oder Diamantschichten und/oder Maskenschichten, die zeit- bzw. teilweise kavitätenabdeckend sind, verwendbar.

Die Mikroventile können in an sich bekannter Weise angesteuert und angetrieben werden oder in der Art und Weise wie in der deutschen Patentanmeldung DE-A-38 11 052.0-31 beschrieben. Die Reaktion in den Kavitäten kann dann durch Bewegen z.B. auf piezoelektrischen Wege, magnetisch, elektrostatisch oder ähnlich erfolgen. Dabei kann eine Nährlösung, ein Mutant, ein Reganz oder ähnliches verdünnt, angereichert, dosiert werden und die Verweilzeit durch jeweiliges Schließen und Öffnen der Mikroventile gesteuert werden. Die Wärmebehandlung oder Kühlbehandlung kann mittels Peltierelementen, Wärmeröhren, Thomson-Joule-Kühler oder ähnlichem durchgeführt werden.

Als Sensoren, angeordnet im gleichen Array in der untersten Schicht, werden wiederum Siliziumsensoren bevorzugt, insbesondere zur Untersuchung von physikalischen oder chemischen Eigenschaften wie Schwarzweiß- oder Grauwert, Kontrast, Trübung, Transmission, Transparenz, Reflektion, Leitfähigkeit, Widerstand, Kapazität, Druck, Dehnung, Temperaturvolumen, -menge, -zeit usw. Zur Auswertung werden die Meßwerte an einen nicht dargestellten Mikroprozessor oder Mikrocomputer weitergegeben. Die Auslesung kann in an sich bekannter Art und Weise folgen, wenn die Auswertung optisch erfolgt, z.B. nach Art der DE-A-38 17 153.8-33.

Die Speicherung bzw. Dokumentation der Daten des Meß- oder Testprogramms sowie die Speicherung von z.B. Patientendaten oder Krankheitsdaten oder Daten von Seren oder Pharmaka kann auf dem gleichen Chip erfolgen (unterste Schicht in Fig. 8 bis 10). Die Speicherung kann entweder mit Hilfe eines optischen Speichers erfolgen, z.B. nach der DE-A-3 804 751 mit amorphen Silizium als Speichermedium (Blasenspeicher) oder als integrierter Halbleiterspeicher (DE-A-38 17 153) oder mit einem RAM-Bauelement (DE-A-37 01 295.9-52). Wie Fig. 9 zeigt, ist es in einfacher Weise möglich bei einer optischen bzw. optoelektronischen Auswertung einen Lichtwellenleiter 15 zu verwenden, der die Mikrokammer oder Kavität 2 im Block 1 durchsetzt oder an sie heranreicht und im interessanten Bereich von seinem Mantel abgeätzt ist und z.B. zur Herbeiführung einer Reaktion beschichtet ist insbesondere mit Substrat.

Abwandlungen der Ausführung nach Fig. 9 sind vielfältig möglich, insbesondere zur photoelektrischen oder anderen lichtelektrischen Auswertung nicht nur mit Hilfe von Lichtleitern. Die Lichtleiter sind vorzugsweise in V-Gruben, an deren Boden anliegend fest angeordnet und nicht nur durchgehend möglich, sondern auch schräg abgeschnitten entsprechend der Neigung der Grube, und wenigstens Teilflächen 15a, 15b des Lichtleiters 15 (Schnittfläche) oder der V-Grube sind verspiegelt. Die Anordnung kann parallel zur Grube, quer zur Grube von oben oder von unten unter einem 90°-Winkel, 180° oder ähnlichem erfolgen. Die Lichtwellenleiter werden herausgeführt und sind zur Auswertung an Photozellen, wie Liniensensoren oder Arrays, angeschlossen zwecks analoger oder bevorzugt digitaler Auslesung. Die Auslesung kann in Zeilen und Reihen erfolgen, z.B. durch Scanner mit Hilfe eines photoelektrischen Liniensensors wie in der DE-OS 3 804 200 beschrieben. Dabei kann ein optischer Bus verwendet werden. Ein geeignetes optisches Datensystem ist beschrieben in der DE-PS 3 619 778. Sender und Empfänger, insbesondere Dioden können in die Baueinheit integriert sein. Die Gruben sind in ihrem V-Winkel (Steilheit einstellbar bzw. veränderbar, siehe DE-A-3 613 181). Integrierte optische Wellenleiter und ihr Aufbau und Anwendungen sind beschrieben in der Zeitschrift Laser und Optoelektronik, Nr. 4, 1986, Seiten 323 bis 336. Auf Seite 338 der gleichen Zeitschrift sind auch Anwendungen von Lichtwellenleitersensoren in der Medizin beschrieben.

In Fig. 10 ist ein Block 1 mit Boden 5 und Deckel 3 mit Mikrokavitäten 2 dargestellt, insbesondere erweitert durch Ausnehmungen im Deckel 3 und Boden 5 - ähnlich der Fig. 7 - wobei jedoch oberhalb der in Array-Anordnung liegenden Mikrokavitäten 2 jeweils Behandlungsöffnungen, Ventile, Zu- und Abfuhrorgane, Fenster, Dotierungsbereiche usw. entsprechend dem Kammervolumen im Deckel 3 angebracht sind, während im Boden 5 z.B. ein Array aus photoelektrischen Zellen oder ein CCD-Array oder ein MOS-Feldeffekttransistor angeordnet ist, der zum Auslesen und Auswerten z.B. über den vorher erwähnten optischen oder einen elektrischen Bus an eine Auswerteeinheit angeschlossen ist, insbesondere mit Mikroprozessoren der Mikrocomputer. Ein Lichtgriffel 16 tastet reihen- und zeilenweise das Array ab, z.B. im Binärcode 8x8 Mikrokavitäten bzw. Zellen oder 10x10 für direkte Digitalabfrage. Anstelle des Lichtgriffels 16 kann auch ein piezoelektrischer, ein kapazitiver, ein magnetischer oder elektrischer Fühler Anwendung finden. Der Stift 16 ist dann zum Anlegen einer Spannung, Kraft- oder Lichteinstrahlung oder ähnlichem geeignet, durch die Fenster 17 im Deckel 3 hindurch in die Kammern 2 des Blocks 1 zur direkten Auslese, z.B. über ein CCD-Array in gleicher Anordnung wie die Mikrokavitäten oder Zellen, hier angedeutet durch die CCD-Zellen 17'. In gleicher Weise kann auch ein MOSFET- oder ein RAM-Bauelement angeordnet sein. Die Auslesung kann auch mit Bauelementen der integrierten Optik durchgeführt werden, insbesondere berührungslos und zweidimensional (vgl. die DE-A-3 605 018 oder die US-A-4 778 989). Anstelle des Lichtgriffels 16 könnte auch eine ionenselektive Meßelektrode als auswechselbares Sensorelement verwendet werden, insbesondere zum Messen der Ionenaktivitäten in Flüssigkeiten und an Gewebeoberflächen. Derartige ionenselektive Meßsysteme sind bekannt und im Handel. Sie beruhen auf einem reinen elektrischen Auswerteprinzip im Gegensatz zur Ausführung der Fig. 9, die z.B. zur optischen Bestimmung der katalytischen Enzymaktivität einer Substanzprobe verwendet wird, wobei die durch die emzymatische Reaktion bedingte Änderung spektraler Eigenschaften eines Enzymsubstrates bzw. dessen Reaktionsprodukte pro Zeiteinheit erfaßt werden. Das Enzymsubstrat wird dem freigelegten Bereich eines Lichtleiters zugeordnet, mit dem die zu messende Probensubstanz in Kontakt gebracht wird.

Bei der Ausführung nach Fig. 10 empfiehlt sich eine Auswertung mit Hilfe eines CCD-Arrays, z.B. nach DE-A-3 817 153 oder mit Hilfe von Halbleitern nach DE-A-3 715 674 oder mit Hilfe von Flüssigkristallelementen, wie z.B. in der DE-C-3 602 796 beschrieben. Mit derartigen Elementen ist eine direkte Speicherung eines Test- oder Analysenergebnisses möglich und jederzeit gezielt abfragbar, auch nach einzelnen Mikrokavitäten.

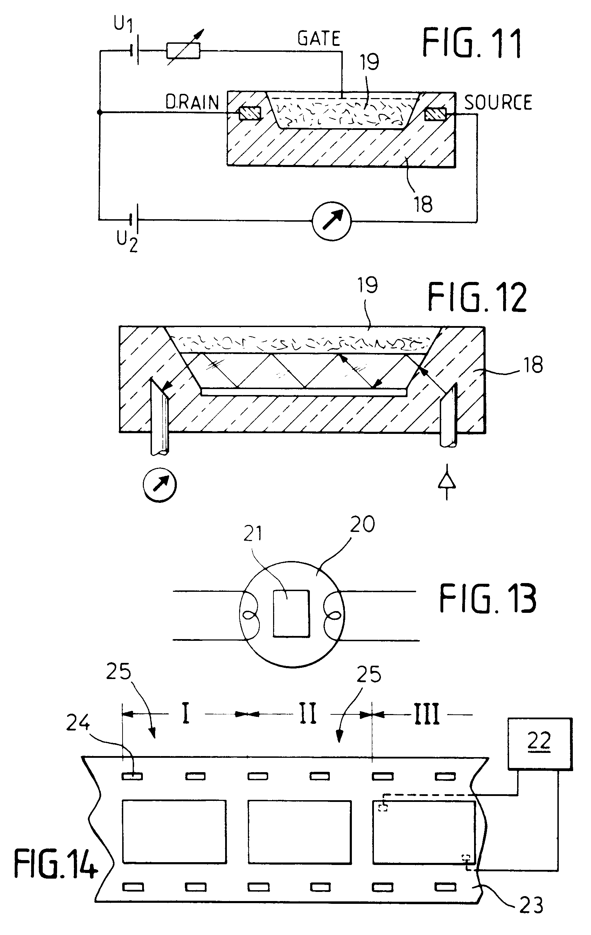

In den Fig. 11 und 12 sind den zu untersuchenden Eigenschaften angepaßte optronische/elektronische Sensoren dargestellt, die allgemein unter dem Begriff "Biosensoren" bekannt sind. Solche Biosensoren arbeiten im allgemeinen mit Feldeffekttransistor 18 in Siliziumtechnologie. Zusammen hergestellt hat der Biosensor dabei eine biologische Komponente auf der Oberfläche, die mit dem Gate des Transistors verbunden ist. Diese biologische Komponente oder das Reagenz- oder Enzymsubstrat 19 muß zur jeweils gewünschten Reaktion fähig sein. Dann kann man, nachdem der Arbeitsbereich optimal eingestellt ist, z.B. bei R mit Hilfe einer oder mehrerer Spannungsquellen U1 , U2, Spannung an Drain and Source anlegen und bei Ionenaktivität entsprechende Veränderungen messen. Die Messung kann nach Fig. 12 auch auf photoelektrischem Wege mit Hilfe von Lichtleitern zwischen Sender und Empfänger, wie Dioden, Lasern, integriert erfolgen. Ein Biosensor der hier in Rede stehenden Art ist in der DE-C-3 634 573 beschrieben.

In Fig. 13 ist ein Sensor auf einem Siliziumwafer 20 rein schematisch dargestellt, wobei ein Sensorchip 21 zur Reaktion mit der Substanzprobe gebracht wird, z.B. einer Bodenprobe, einer Flüssigkeitsprobe, einer Lebensmittelprobe oder einer Gewebeprobe mit Schadstoffen darin, deren Anteil z.B. bestimmt werden soll. Es kann auch ein Sauerstoffbedarf oder Sauerstoffgehalt oder ähnliches bestimmt werden. Der Sensor ist ein üblicher Termistor- bzw. Leitfähigkeitssensor. Auch Schall- oder Ultraschall- oder Infraschallsensoren sind geeignet, wenn die Probe hiermit beaufschlagt werden soll. Miniaturmikrofone sind bekannt.

In Fig. 14 ist das Ausführungsbeispiel eines Testautomaten dargestellt. Ein Mikrocomputer oder Mikroprozessor übernimmt die Steuerung des Testablaufs nach einem vorgegebenen Testprogramm. Das Programm kann in einem externen Speicher auswechselbar enthalten sein, z.B. in einem PROM oder EPROM oder einem löschbaren Schreiblesespeicher. Patientendaten, Daten der zu testenden Stoffe, der Reagenzien etc. sind ebenfalls austauschbar und nach Ablauf eines Tests werden die Testergebnisse im Mikrocomputer oder Mikroprozessor ebenfalls gespeichert, insbesondere in einem Speicher für wahlfreien Zugriff und die Aufzeichnung selbst dokumentierend, z.B. als CCD-Bild, Wärmebild oder auf Magnetband piezoresistiv, elektrostatisch bzw. ferroelektrisch etc.

Im Ausführungsbeispiel nach Fig. 14 ist ein Filmträger 23 dargestellt, auf dem Makrochips aus einer Vielzehl einzelner Chips nach den Fig. 1 bis 5 aufgeklebt oder lösbar befestigt ist, wobei der Filmträger eine Transportperforation 24 aufweist, um den Film mit den üblichen Filmtransporten, wie Malteserkreuz von Rolle zu Rolle über eine Behandlungszeit des Programms gesteuert, und von Station zu Station 25, d.h. hier I-X, zu führen. Dabei werden zunächst ein oder mehrere Stoffe nach dem Testprogramm in die Mikrokavitäten der Chips in Station I eingefüllt. In Station II erfolgt dann eine Reaktion, entweder mit oder ohne Behandlung, und nach Ablauf einer Reaktionszeit wird automatisch gemessen und weitertransportiert in die Teststation III, um gegebenenfalls weitere Tests durchzuführen, wobei die Testergebnisse automatisch den einzelnen Kavitäten zugeordnet werden, gegebenenfalls einzelnen Probesubstanzherkünften, sowie Patienten. Die Selbstdokumentation und Speicherung erfolgt im Mikrocomputer oder Mikroprozessor 22 zur automatischen Teststeuerung und Testanwendung.

## Patentansprüche

1. Mikromechanische Struktur mit Kavitäten, Öffnungen, Kanälen, Erhebungen (2,4) zur Aufnahme und Untersuchung von Probesubstanzen auf etwaige Änderungen physikalischer und/oder chemischer und/oder biologisch-chemischer Eigenschaften unter gezielter Auswertung und Dokumentation für die Zwecke der Biotechnologie, Gentechnologie, Zell- und Immunforschung und anderer medizinischer, agrarischer und Umweltforschung, **dadurch gekennzeichnet,** daß die Struktur aus einem Stück (Block 1) und einem Gegenstück (Deckel 3) besteht, wobei das erste Stück aus halbleitendem Material (der Gruppe III bis V der Elemente des Periodensystems) oder Glas oder Keramik, Diamant oder Kohlenstoff besteht oder enthält und das Gegenstück aus einem chemisch ätzbaren (kristallinen) Material besteht und wobei beide Stücke in chemischer Ätztechnik in Maskentechnik mit Hilfe geometrisch identischer Masken hergestellt werden, sodaß beide Stücke zueinander passen.

2. Mikrostruktur nach Anspruch 1, **dadurch gekennzeichnet,** daß der Block und Deckel aus gleichem Material bestehen.

3. Mikrostruktur nach Anspruch 1 oder 2, **dadurch gekennzeichnet,** daß der Block oder Deckel aus Silizium oder anderem einkristallinem Material oder Glas bestehen.

4. Mikrostruktur nach einem der vorhergehenden Ansprüche, **dadurch gekennzeichnet,** daß in dem Block eine Vielzahl von Kavitäten bestimmter Form, Größe, Anordnung bzw. Verteilung über die dem Deckel zugekehrte Oberfläche eingebracht sind.

5. Mikrostruktur nach Anspruch 4, **dadurch gekennzeichnet,** daß die Kavitäten durch richtungsabhängiges chemisches Ätzen eingebracht sind.

6. Mikrostruktur nach Anspruch 4, **dadurch gekennzeichnet,** daß die Kavitäten durch anisotropes Ätzen eingebracht sind.

7. Mikrostruktur nach Anspruch 4, **dadurch gekennzeichnet,** daß der Deckel mit zu den Kavitäten im Block komplementären Erhebungen versehen ist und beide hermetisch dicht zueinander passen.

8. Mikrostruktur nach Anspruch 4, **dadurch gekennzeichnet,** daß die Vielzahl von Kavitäten nebeneinander über die Oberfläche verteilt angeordnet sind.

9. Mikrostruktur nach einem der vorhergehenden Ansprüche, **dadurch gekennzeichnet,** daß das Anordnungsmuster der Kavitäten nach einem Rastermaß aufgebaut ist, so daß es (in X-Y-Richtung) von automatischen Füll- bzw. Entleerungsorganen bzw. Probenehmern, Pumpen, Saughebern, o.ä. Mundstücken hiervon insbesondere nach einem vorgegebenen Programm abrastbar ist, wobei insbesondere Mikroventile im selben Rastermaß angeordnet von außen ansteuerbar sind.

10. Mikrostruktur nach Anspruch 8 oder 9, **dadurch gekennzeichnet,** daß im gleichen Rastermaß Öffnungen (verschließbar) oder Fenster dem Deckel und optische, optronische, elektronische, piezoelektrische, ferritische, magnetische, kapazitive, ohmsche oder andere Meß- und Auswerteeinrichtungen wie CCD- oder RAM oder andere Arrays dem Boden zugeordnet sind und dieses Array oder die Matrix direkt mit einem Mikroprozessor (MP) oder Mikrocomputer (MC) verbunden ist.

11. Mikrostruktur nach Anspruch 10, **dadurch gekennzeichnet,** daß die Meßergebnisse aus den Kavitäten und Zellen automatisch abfragbar und selbstdokumentierend sind (Ergebnisspeicher).

12. Mikrostruktur nach einem der Ansprüche 8 bis 10, **dadurch gekennzeichnet,** daß wenigstens in eine Kavität ein angeätzter Lichtwellenleiter einmündet, der direkt einer optischen Auswertung zugänglich ist.

13. Mikrostruktur nach einem der Ansprüche 8 bis 11, **dadurch gekennzeichnet,** daß den einzelnen Kavitäten/Zellen zur äußeren Beeinflussung ein Stift (Lichtgriffel o.ä.) zuortbar ist (in X-Y-Richtung).

14. Mikrostruktur **dadurch gekennzeichnet,** daß mehrere Strukturen (Chips) gemäs Anspruch 1 auf einem Filmträger angeordnet sind, zum Transport von Station zu Station zur automatischen Steuerung und Auswertung.

## Claims

1. Micro-mechanical structure with cavities, openings, channels and elevations (2, 4) for accommodation and examination of sampling substances for possible changes in physical and/or chemical and/or biological-chemical properties with specified evaluation and documentation for purposes in biotechnology, gentechnology, cell and immune research and other medical, agricultural and environmental research, **characterised in that** the structure comprises a first part (block 1) and a counterpart (cover 3), in which respect the first part is made of, or contains, a semi-conductive material (of groups III to V of the elements of the periodic system) or glass or ceramic, diamond or carbon, and the counterpart is made of a chemically corroding (crystalline) material, in which respect both parts are produced by chemical masked etching with the aid of geometrically identical masks, so that both parts will match.

2. Microstructure according to claim 1, **characterised in that** the block and cover are made of the same material.

3. Microstructure according to claim 1 or 2, **characterised in that** the block or cover are made of silicon or another unicrystalline material or glass.

4. Microstructure according to one of the above claims, **characterised in that** the block is provided with a plurality of cavities of specified form, size, arrangement or distribution over the surface facing towards the cover.

5. Microstructure according to claim 4, **characterised in that** the cavities are produced by direction-dependent chemical etching.

6. Microstructure according to claim 4, **characterised in that** the cavities are produced by anisotrop etching.

7. Microstructure according to claim 4, **characterised in that** the cover is provided with elevations which complement the cavities in the block, and that both fit hermetically.

8. Microstructure according to claim 4, **characterised in that** the plurality of cavities are arranged alongside one another and spaced over the surface.

9. Microstructure according to one of the above claims, **characterised in that** the arrangement pattern of the cavities follows a grid of lines in such a manner that it can be probed (in the X-Y direction), in particular according to a specified program, by automatic charging and discharging elements or samplers, pumps, siphons or similar mouth pieces, and that in particular microvalves are arranged in the same grid of lines and externally controlled.

10. Microstructure according to claim 8 or 9, **characterised in that** in the same grid of lines openings (sealable) or windows are associated with the cover, and optical, optronic, electronic, piezoelectric, ferritic, magnetic, capacitive, ohm or other measuring and evaluation devices, such as CCD- or RAM, or other arrays are associated with the base, and that this array or the matrix is directly connected to a microprocessor (MP) or a microcomputer (MC).

11. Microstructure according to claim 10, **characterised in that** the measuring results from the cavities and cells are automatically interrogated and selfdocumenting (result store).

12. Microstructure according to one of claims 8 to 10, **characterised in that** an etched lightwave duct, which is directly accessible for optical evaluation, terminates into at least one cavity.

13. Microstructure according to one of claims 8 to 11, **characterised in that** a pen (light pen or similar) can be allocated (in the X-Y direction) to the individual cavities/cells for the purpose of external manipulation.

14. Microstructure, **characterised in that** a plurality of structures (chips) according to claim 1 is arranged on a film base for transport from station to station of automatic control and evaluation.

## Revendications

1. Structure micromécanique comportant des cavités, des ouvertures, des canaux, des surélévations (2, 4), destinée à recevoir des substances d'essais en vue d'étudier, en les exploitant et en les enreegistrant, d'éventuelles modifications de leurs propriétés physiques et/ou chimiques et/ou biologico-chimiques dans le domaine de la biotechnologie, du génie génétique, de la recherche en cytologie et en immunologie ainsi que dans d'autres domaines de la recherche médicale, de la recherche agricole et de l'environnement, caractérisée par le fait que la structure est constituée par un premier élément (bloc 1) et un élément conjugué (couvercle 3), le premier élément étant réalisé en un matériau semi-conducteur (appartenant aux groupes III à V de la classification périodique des éléments) ou en verre, en céramique, en diamant ou en carbone ou encore contenant l'un de ces éléments, tandis que l'élément conjugué est réalisé en un matériau (cristallin) pouvant être attaqué chimiquement, les deux éléments étant réalisés par un procédé d'attaque chimique suivant la technique des masques, à l'aide de masques identiques de telle sorte que les deux éléments soient mutuellement adaptés.

2. Microstructure selon la revendication 1, caractérisée par le fait que le bloc et le couvercle sont réalisés en un même matériau.

3. Microstructure selon la revendication 1 ou 2, caractérisé par le fait que le bloc ou le couvercle est en silicium ou en un autre matériau monocristallin ou en verre.

4. Microstructure selon l'une des revendications précédentes, caractérisé par le fait qu'une pluralité de cavités avec une forme, une taille, une disposition et une répartition déterminées sont aménagées dans la surface du bloc tournée vers le couvercle.

5. Microstructure selon la revendication 4, caractérisé par le fait que les cavités sont réalisées par attaque chimique orientée.

6. Microstructure selon la revendication 4, caractérisé par le fait que les cavités sont réalisées par attaque anisotrope.

7. Microstructure selon la revendication 4, caractérisé par le fait que le couvercle est pourvu de surélévations complémentaires aux cavités du bloc et que les deux éléments sont mutuellement adaptés pour former un ensemble hermétique.

8. Microstructure selon la revendication 4, caractérisée par le fait que la pluralité de cavités sont réparties, les unes à côté des autres sur la surface.

9. Microstructure selon l'une des revendications précédentes, caractérisé par le fait que le modèle de répartition des cavités est établi en fonction d'une dimension de réseau de telle sorte que celle-ci puisse être parcourue (dans les directions X-Y) par des organes de remplissage ou de vidage, des dispositifs de prélèvement d'échantillon, des pompes, des pipettes ou des embouts analogues, notamment suivant un programme pré-établi, en particulier des micro-valves disposées avec la même dimension de réseau pouvant être commandées à partir de l'extérieur.

10. Microstructure selon la revendication 8 ou 9, caractérisée par le fait que des ouvertures (obturables) ou des fenêtres sont associées au couvercle avec la même dimension de réseau et des dispositifs optiques, optroniques, électroniques, piézo-électriques, ferritiques, magnétiques, capacitifs, ohmiques ou d'autres dispositifs de mesure et d'exploitation tels que des réseaux CCD, RAM ou autres sont associés au fond avec la même dimension de réseau et par le fait que ces réseaux ou la matrice sont connectés directement à un microprocesseur (MP) ou un micro-ordinateur (MC).

11. Microstructure selon la revendication 10, caractérisée par le fait que les résultats des mesures pour les cavités et cellules sont lus et enregistrés de manière automatique (mémoire de résultat).

12. Microstructure selon l'une des revendications 8 à 10, caractérisée par le fait qu'une fibre optique dénudée arrive dans au moins une cavité, laquelle fibre optique est directement accessible pour une exploitation optique.

13. Microstructure selon l'une des revendications 8 à 11, caractérisée par le fait qu'un crayon (photostyle ou analogue) peut être associé aux différentes cavités/cellules (dans la direction X-Y) aux fins d'action extérieure.

14. Microstructure, caractérisée par le fait que plusieurs structures selon la revendication 1 (substrats) sont disposées sur un film support à des fins d'acheminement de poste en poste pour la commande du déroulement et l'exploitation automatiques.
